# FASCICULE DE BREVET EUROPEEN

(11) **EP 3 479 649 B1**
(45) Date de publication et mention de la délivrance du brevet: **02.10.2019**
(21) Numéro de dépôt: 17745820.5
(22) Date de dépôt: 03.07.2017
(51) Int. Cl.: H05K 1/00, G01D 1/00, H04L 29/14, H04W 88/08, H04W 84/10

(54) **DISPOSITIF DE COMMUNICATION MODULAIRE**
MODULARE KOMMUNIKATIONSVORRICHTUNG
MODULAR COMMUNICATION DEVICE

(30) Priorité: 04.07.2016 FR 1656360
(43) Date de publication de la demande: 08.05.2019
(73) Titulaire: Kerlink, 35235 Thorigne-Fouillard (FR)
(72) Inventeur: NICOLAS, Samuel, 35510 Cesson Sevigne (FR); DELIBIE, Yannick, 35235 Thorigne-Fouillard (FR)
(74) Mandataire: Loyer & Abello
(86) Numéro de dépôt international: PCT/FR2017/051804
(87) Numéro de publication internationale: WO 2018/007742

(56) Documents cités:
- FR-A1- 2 547 082
- FR-A1- 2 957 747
- US-A1- 2013 114 229
- US-A1- 2015 288 532

## Description

### Domaine technique

L'invention se rapporte au domaine des dispositifs électroniques modulaires, en particulier pour les communications numériques sans fil.

### Arrière-plan technologique

L'Internet des objets consiste à permettre à des objets du quotidien de communiquer automatiquement des données avec un réseau sans-fil. Par exemple, un compteur d'eau équipé d'un module de communication peut automatiquement communiquer un relevé d'eau à l'entreprise de gestion de la facturation de la consommation d'eau.

Des passerelles de concentration, également appelées stations de base, ont pour rôle d'assurer la réception et l'émission radio de données en provenance et à destination des module de communication présents dans leur zone de couverture ainsi que de relayer ces données à des équipements en charge de les traiter, par exemple des serveurs accessibles sur un réseau basé sur le protocole IP (« Internet Protocol »).

Plusieurs technologies d'accès radio sont disponibles pour la mise en oeuvre de réseaux de modules de communication. On peut citer à titre purement illustratif et non limitatif les technologies LoRa™, Sigfox™ ou encore WM-Bus (de l'anglais « *Wireless Meter Bus* »), qui reposent notamment sur des types de modulation différents.

Ces technologies ont en commun de proposer des communications à longue distance (dites « long range » en anglais) qui permettent de diminuer le nombre de passerelles en augmentant la couverture de celles-ci.

Il est avantageux de fournir des passerelles de structure modulaire supportant une ou plusieurs cartes rangées dans un coffret, chacune permettant de connecter un réseau ou un service particulier. Cependant, en l'absence d'intelligence logicielle sur les cartes, notamment en l'absence d'attribution d'adresse pour chaque carte, chaque carte doit être conçue de façon spécifique en fonction du rang qu'elle occupe dans le coffret.

US 2013/114229 A1 divulgue une chaîne de circuits imprimés connectés les uns aux autres à l'aide de câbles électriques bidirectionnels dans un schéma de permutation quasi circulaire.

FR 2 957 747 A1 divulgue une chaîne électronique formée par une pluralité de circuits imprimés identiques ayant chacun le même nombre de voies de connexion et reliés entre eux par permutation circulaire des voies de connexion.

### Résumé

L'invention se rapporte au dispositif défini dans la revendication 1. Des modes de réalisation complémentaires sont définis dans les revendications dépendantes.

Une idée à la base de l'invention est de proposer une structure compatible avec une fabrication en série de cartes interchangeables.

Certains aspects de l'invention viennent de l'idée de pouvoir fournir des cartes périphériques indépendantes de leur rang dans un dispositif modulaire, par exemple un dispositif d'interconnexion de réseau.

Certains aspects de l'invention viennent de l'idée de pouvoir fournir des cartes de connexion standardisées.

Certains aspects de l'invention viennent de l'idée de pouvoir se passer de cartes de fond de panier.

Dans un mode de réalisation, l'invention fournit un dispositif de communication modulaire comportant
- un élément maître comportant une unité de commande apte à générer des signaux électriques de type série, comportant en outre N entrées-sorties de commande électriques bidirectionnelles, chacune connectée électriquement à l'unité de commande,
- une série d'éléments modulaires, chaque élément modulaire comportant :
   ∘ une interface de connexion amont comportant une série de N bornes d'entrée-sorties amont disposées à des emplacements formant un motif prédéterminé,
   ∘ une interface de connexion aval comportant une série de N bornes d'entrée-sorties aval disposées à des emplacements formant le même motif prédéterminé,
   ∘ une pluralité de liaisons électriques bidirectionnelles, chaque liaison électrique bidirectionnelle reliant une borne d'entrée-sortie amont située à un emplacement de rang i au sein du motif prédéterminé de l'interface de connexion amont à une borne d'entrée-sortie aval située à un emplacement de rang i-1 au sein du motif prédéterminé de l'interface de connexion aval, de manière à réaliser une permutation circulaire entre les rangs des bornes d'entrée-sortie amont et aval reliées électriquement deux à deux, et dans laquelle l'une des liaisons électriques est une liaison de commande locale desservant un module électronique de communication auquel sont destinés les signaux électriques de type série, dans laquelle la borne d'entrée-sortie amont reliée à ladite liaison de commande locale est une borne de commande locale amont disposée à un emplacement de rang prédéterminé au sein du motif de l'interface de connexion amont, de sorte que l'emplacement de la borne de commande locale amont au sein du motif de l'interface de connexion amont soit le même emplacement pour tous les éléments modulaires,
dans lequel les éléments modulaires sont connectés les uns aux autres via les interfaces de connexion amont et aval, l'interface de connexion amont de chaque élément modulaire et l'interface de connexion aval de chaque élément modulaire étant complémentaires et aptes à connecter les bornes d'entrée-sortie aval d'un élément modulaire aux bornes d'entrée-sortie amont de même rang de l'élément modulaire suivant, dans lequel les bornes d'entrée sortie amont du premier élément modulaire sont connectées aux bornes entrées-sorties de commande électriques bidirectionnelles de l'élément maître, et dans lequel la série d'éléments modulaires comporte un nombre d'éléments modulaires supérieur à N.

Grâce à des caractéristiques de l'invention, il est possible d'obtenir un dispositif d'interconnexion de réseaux dans lequel :
- la connexion entre les différents éléments modulaires est standardisée. Ceci permet un gain en modularité par rapport à l'art antérieur.
- les communications sont bidirectionnelles à travers les liaisons électriques et les bornes d'entrée-sortie amont et aval.
- tout type de signal électrique peut être communiqué à travers le dispositif d'interconnexion de réseau.

Dans des modes de réalisation, le dispositif de communication modulaire selon l'invention peut comporter en outre une ou plusieurs des caractéristiques ci-dessous.

Dans des modes de réalisation, l'unité de commande est configurée pour générer un signal électrique multiplexé sur une des N entrées-sorties de commande électriques bidirectionnelles, le signal électrique comportant des premiers signaux de commandes destinés à un premier module électronique de communication d'un premier élément modulaire de la série d'éléments modulaires et deuxièmes signaux de commandes destinés à un deuxième module électronique de communication d'un deuxième élément modulaire de la série d'éléments modulaires, les premiers signaux de commandes et les deuxièmes signaux de commandes étant multiplexés temporellement.

Dans des modes de réalisation, la série d'éléments modulaires comporte un nombre d'éléments modulaires supérieur ou égal à N.

Dans des modes de réalisation, le nombre d'éléments modulaires de la série d'éléments modulaires est supérieur à N, et dans lequel un rang i du premier élément modulaire dans la série d'éléments modulaires et un rang j du deuxième élément modulaire dans la série d'éléments modulaires présente une relation j=i[N], de sorte que le premier élément modulaire et le deuxième élément modulaire sont reliés en série à ladite entrée-sortie de commande électriques bidirectionnelle.

Dans des modes de réalisation, l'unité de commande est configurée pour générer un signal électrique multiplexé sur deux des N entrées-sorties de commande électriques bidirectionnelles, le signal électrique comportant des premiers signaux de commandes destinés à un premier module électronique de communication d'un premier élément modulaire de la série d'éléments modulaires et des deuxièmes signaux de commandes destinés à un deuxième module électronique de communication d'un deuxième élément modulaire de la série d'éléments modulaires, les premiers signaux de commandes et les deuxièmes signaux de commandes étant multiplexés temporellement.

Dans des modes de réalisation, l'unité de commande est configurée pour générer un signal électrique multiplexé sur l'ensemble des N entrées-sorties de commande électriques bidirectionnelles, le signal électrique multiplexé comportant des signaux de commandes destinés à chacun des modules électronique de communication des éléments modulaires de la série d'éléments modulaires, les signaux de commandes étant multiplexés temporellement.Dans des modes de réalisation, chaque élément modulaire comporte une carte périphérique et une carte de connexion sui sont branchées l'une sur l'autre. La carte de connexion peut être située en amont ou en aval de la carte périphérique.

Selon un mode de réalisation dans lequel la carte de connexion est située en amont de la carte périphérique;
- la carte périphérique comporte :
   ∘ l'interface de connexion aval, la carte périphérique comportant en outre :
      ∘ une interface intermédiaire comportant une série de N bornes d'entrée-sorties amonts disposées à des emplacements formant un second motif prédéterminé,
      ∘ une pluralité de liaisons électriques bidirectionnelles, chaque liaison électrique bidirectionnelle reliant une borne d'entrée-sortie amont située à un emplacement de rang i au sein du motif prédéterminé de l'interface intermédiaire à une borne d'entrée-sortie aval située à un emplacement de rang i au sein du second motif prédéterminé de l'interface de connexion aval de la carte périphérique, dans laquelle l'une des liaisons électriques est la liaison de commande locale, l'emplacement de la borne de commande locale amont au sein du motif de l'interface intermédiaire étant le même emplacement pour toutes les cartes périphériques,
- la carte de connexion comporte :
   ∘ l'interface de connexion aval, la carte de connexion comportant en outre :
      ∘ une interface intermédiaire comportant une série de N bornes d'entrée-sorties aval disposées à des emplacements formant le même second motif prédéterminé,
      ∘ une pluralité de liaisons électriques bidirectionnelles, chaque liaison électrique bidirectionnelle reliant une borne d'entrée-sortie amont située à un emplacement de rang i au sein du second motif prédéterminé de l'interface de connexion aval de la carte de connexion à une borne d'entrée-sortie aval située à un emplacement de rang i-1 au sein du motif prédéterminé de l'interface intermédiaire, de manière à réaliser une permutation circulaire entre les rangs des bornes d'entrée-sortie amonts et aval reliées électriquement deux à deux, la carte périphérique et la carte de connexion étant connectées l'une à l'autre via les interfaces intermédiaires, l'interface intermédiaire de la carte de connexion et l'interface intermédiaire de la carte périphérique étant complémentaires et aptes à connecter les bornes d'entrée-sorties amonts de l'interface intermédiaire de la carte périphérique aux bornes d'entrée-sorties aval de même rang de l'interface intermédiaire de la carte de connexion.

Alternativement, dans le mode de réalisation dans lequel la carte de connexion est située en aval de la carte périphérique ;
- la carte périphérique comporte :
   ∘ l'interface de connexion amont, la carte périphérique comportant en outre :
      ∘ une interface intermédiaire comportant une série de N bornes d'entrée-sorties aval disposées à des emplacements formant un second motif prédéterminé,
      ∘ une pluralité de liaisons électriques bidirectionnelles, chaque liaison électrique bidirectionnelle reliant une borne d'entrée-sortie amont située à un emplacement de rang i au sein du motif prédéterminé de l'interface de connexion amont à une borne d'entrée-sortie aval située à un emplacement de rang i au sein du second motif prédéterminé de l'interface intermédiaire de la carte périphérique, dans laquelle l'une des liaisons électriques est la liaison de commande locale, l'emplacement de la borne de commande locale au sein du motif de l'interface intermédiaire ayant le même emplacement pour toutes les cartes périphériques,
- la carte de connexion comporte :
   ∘ l'interface de connexion aval, la carte de connexion comportant en outre :
      ∘ une interface intermédiaire comportant une série de N bornes d'entrée-sorties amont disposées à des emplacements formant le même second motif prédéterminé,
      ∘ une pluralité de liaisons électriques bidirectionnelles, chaque liaison électrique bidirectionnelle reliant une borne d'entrée-sortie amont située à un emplacement de rang i au sein du second motif prédéterminé de l'interface intermédiaire de la carte de connexion à une borne d'entrée-sortie aval située à un emplacement de rang i-1 au sein du motif prédéterminé de l'interface de connexion aval, de manière à réaliser une permutation circulaire entre les rangs des bornes d'entrée-sortie aval et amont reliées électriquement deux à deux,
la carte périphérique et la carte de connexion étant connectées l'une à l'autre via les interfaces intermédiaires, l'interface intermédiaire de la carte de connexion et l'interface intermédiaire de la carte périphérique étant complémentaires et aptes à connecter les bornes d'entrée-sorties aval de même rang de l'interface intermédiaire de la carte périphérique aux bornes d'entrée-sorties amont de l'interface intermédiaire de la carte de connexion.

Grâce à ces caractéristiques, il est possible d'obtenir un dispositif d'interconnexion de réseaux dans lequel :
- les cartes de connexion sont identiques. Ceci permet un gain en coût par rapport à l'art antérieur car des cartes d'une seule référence suffisent.
- la connexion entre les différentes cartes périphériques est standardisée. Ceci permet un gain en modularité par rapport à l'art antérieur.
- les communications sont bidirectionnelles à travers les liaisons électriques et les bornes d'entrée-sortie amont et aval.
- tout type de signal électrique peut être communiqué à travers le dispositif d'interconnexion de réseau.

Dans un mode de réalisation, la carte périphérique comporte le module électronique de communication, le module électronique de communication étant configuré pour communiquer sans fil avec des objets connectés, et dans lequel les signaux électriques émis par l'unité de commande sont destinés aux objets connectés.

Selon ses fonctionnalités, le module électronique de communication peut comporter toutes sortes de composants électriques et électroniques, notamment circuit imprimé, microprocesseur, interrupteurs, condensateurs, transistors, diodes, résistances, interfaces radio, convertisseurs analogique-numérique (CAN) et numérique-analogique (CNA) etc.

Le module électronique de communication est apte à recevoir d'un appareil ou d'un réseau, par exemple d'un réseau radio, des signaux électriques, par exemple des signaux radio, et à les transmettre à l'unité de commande. Le module électronique de communication est en outre apte à recevoir de l'unité de commande des signaux électriques et à les transmettre à un appareil ou un réseau, par exemple un réseau radio.

Dans un mode de réalisation, le module électronique de communication comporte une borne radio apte à être connectée à une antenne radio pour émettre des signaux radios, le module électronique de communication comportant un module de traitement en bande de base apte à démoduler les signaux électriques pour obtenir des signaux radio destinés à des objets connectés.

Dans un mode de réalisation, la borne radio est en outre apte à être connectée à une antenne radio pour recevoir des signaux radios en provenance d'objets connectés, le module de traitement en bande de base étant en outre apte à démoduler les signaux radios pour obtenir des signaux électriques destinés à l'unité de commande.

Dans un mode de réalisation, le module de traitement en bande de base est configuré pour utiliser des protocoles radios sélectionnés dans la liste consistant en : SigFox, LoRa, WM-Bus, Z-Wave

Dans un mode de réalisation, les bornes d'entrée-sortie des interfaces de connexion aval et amont comportent respectivement des connecteurs mâles et des connecteurs femelles complémentaires les uns des autres, le connecteur mâle présentant une broche conductrice d'électricité et le connecteur femelle présentant un orifice conducteur d'électricité apte à établir une liaison électrique avec la broche conductrice.

Dans un mode de réalisation, les bornes d'entrée-sortie des deux interfaces intermédiaires comportent respectivement des connecteurs mâles et des connecteurs femelles complémentaires les unes des autres, le connecteur mâle présentant une broche conductrice d'électricité correspondant à une borne d'entrée-sortie amont ou aval et le connecteur femelle présentant un orifice conducteur d'électricité apte à établir une liaison électrique avec la broche conductrice.

Dans un mode de réalisation, les signaux électriques comportent des signaux de commande logique, par exemple un signal de type liens série, Interruption, Input/ouput, chipselect etc. Les signaux électriques peuvent également comporter des signaux de données, par exemple de mise à jour d'horloge ou de données de géolocalisation.

Passerelle de concentration de données comportant le dispositif de communication modulaire selon l'un quelconque des modes de réalisation décrits ci-dessus et une interface réseau apte à établir une connexion entre un réseau et l'unité de commande.

### Brève description des figures

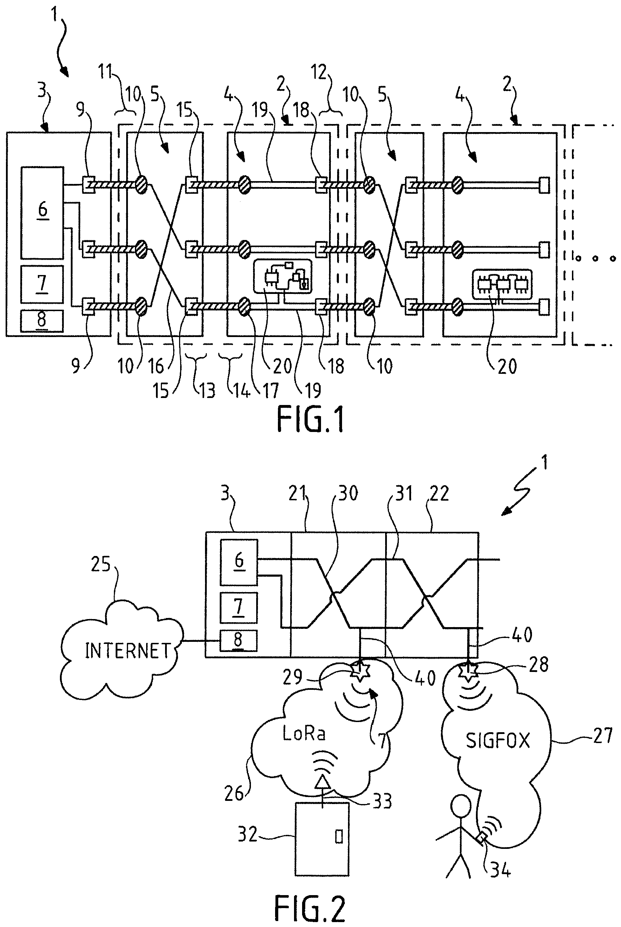

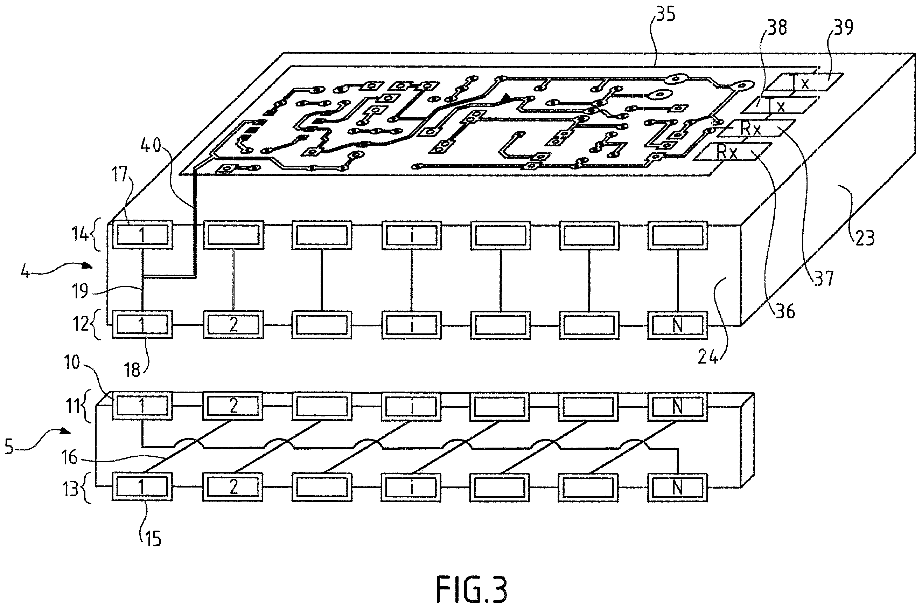

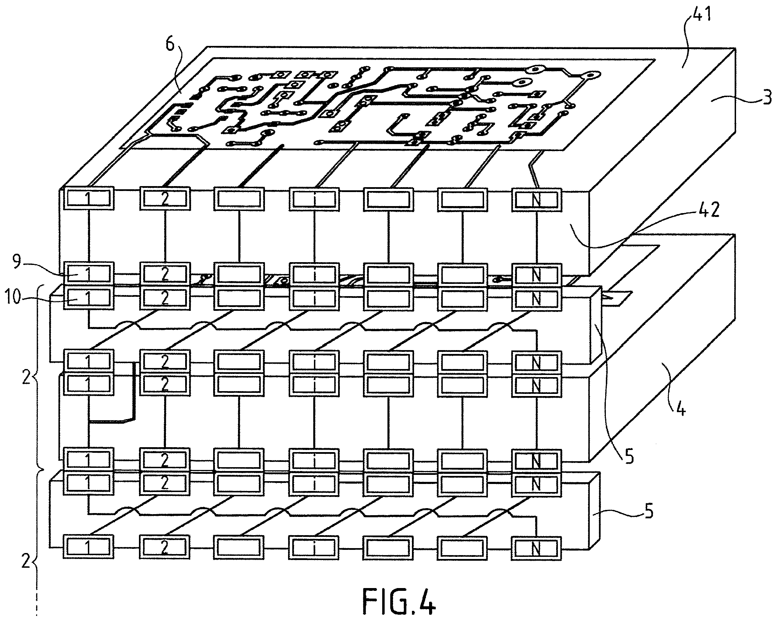

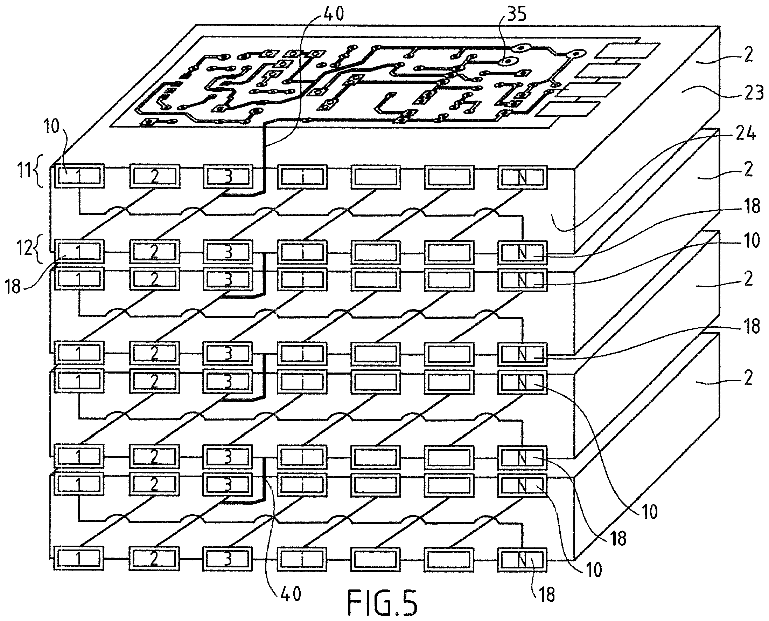

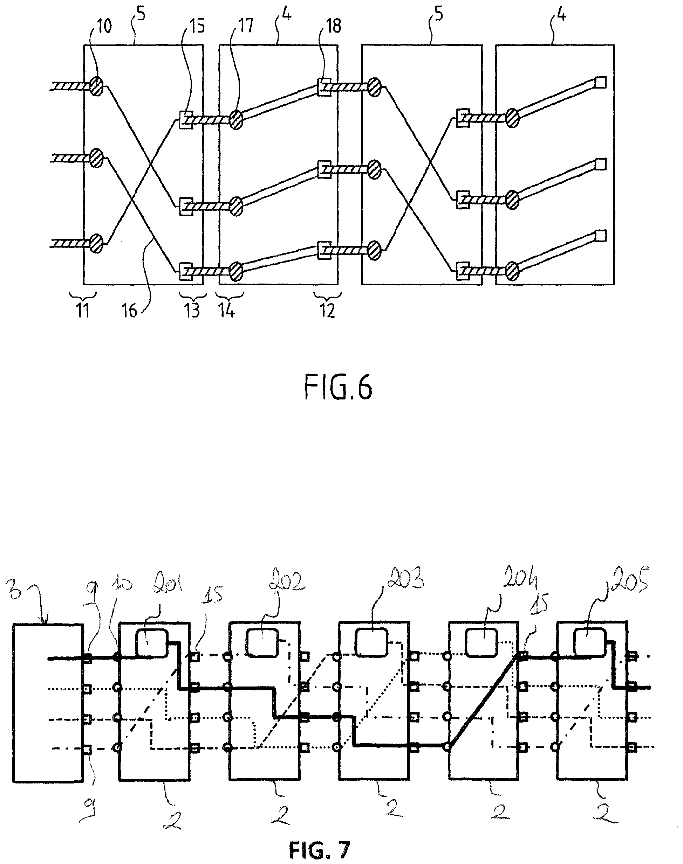

L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés.
- **La** **figure 1** est un schéma représentant un dispositif d'interconnexion de réseau conçu de façon modulaire.
- **La** **figure 2** est un schéma représentant le dispositif d'interconnexion de réseau de la figure 1, communiquant avec des objets connectés.
- **La** **figure 3** est un schéma d'un élément modulaire selon un premier mode de réalisation.
- **La** **figure 4** est un schéma de chainage d'éléments modulaires selon le premier mode de réalisation.
- **La** **figure 5** est un schéma de chainage d'éléments modulaires selon un second mode de réalisation.
- **La** **figure 6** représente une variante de connectivité des cartes périphériques et des cartes de connexion.
- **La** **figure 7** représente un schéma de chainage d'éléments modulaires selon un mode de réalisation.

### Description détaillée de modes de réalisation

La figure 1 représente un dispositif d'interconnexion de réseau 1 selon un mode de réalisation de l'invention. Un tel dispositif, également appelé station de base ou passerelle, est conçu de façon modulaire de façon à transmettre des signaux électriques entre un élément maître 3 et des éléments modulaires 2.

Les éléments modulaires 2 sont connectés entre eux par chainage, un des éléments modulaires 2 étant directement connecté à l'élément maître 3.

L'élément maître 3 comporte toute l'intelligence logicielle du dispositif d'interconnexion de réseau 1. Les éléments modulaires 2 comportent des cartes périphériques 4 de transmission radio aptes à convertir des signaux de commande reçus de l'élément maître en instructions vers ou provenant d'un objet distant en utilisant des protocoles radio.

L'élément maître 3, également appelé carte mère, comporte une unité de commande 6. Une telle unité de commande 6 est par exemple une unité de traitement centrale, en anglais « central processing unit » (CPU), apte à exécuter des instructions enregistrées sur un support (non représenté) afin de générer ou de transmettre des signaux électriques.

L'élément maître 3 comporte en outre un port d'alimentation électrique 7 ou une batterie apte à alimenter le dispositif d'interconnexion de réseau 1 en énergie électrique.

L'élément maître 3 comporte en outre une interface 8 avec un appareil ou un réseau. Par exemple, l'interface 8 est un port de câble RJ45.

Optionnellement, l'élément maître 3 comporte en outre un port de câble coaxial, par exemple apte à recevoir une antenne de système de positionnement mondial, en anglais « Global Positioning System » (GPS) (non représentée).

L'élément maître 3 comporte N entrées-sorties 9 de commande électriques bidirectionnelles, chacune connectée électriquement à l'unité de commande 6. Dans l'exemple représenté sur la figure 1, l'élément maître 3 comporte 3 entrées-sorties de commande électrique.

Le dispositif d'interconnexion de réseau 1 comporte au maximum autant d'éléments modulaires 2 qu'il ne comporte d'entrée-sorties 9 de commandes électriques. Dans l'exemple de la figure 1, le dispositif d'interconnexion de réseau 1 comporte au maximum 3 éléments modulaires 2.

Les éléments modulaires 2 peuvent être standardisés, comme décrit ci-dessous.

Chaque élément modulaire 2 comporte des bornes d'entrée-sorties amont 10 disposées selon un motif en ligne au niveau d'une interface de connexion amont 11.

Par exemple, les bornes d'entrée-sorties amont 10 sont des broches électriques mâles.

Chaque élément modulaire 2 comporte des bornes d'entrée-sortie aval 18 disposées également selon ce motif en ligne au niveau d'une interface aval 12.

Par exemple, les bornes d'entrée-sorties aval 18 sont des broches électriques femelles.

Chaque élément modulaire 2 comporte des liaisons électriques connectant les bornes d'entrée-sorties amont 10 et les bornes d'entrée-sortie aval 18 deux à deux en permutation circulaire.

Ces liaisons électriques sont par exemple des liaisons de type bus universel en série, en anglais « universal serial bus » (USB).

Dans l'exemple de la figure 1, chaque élément modulaire 2 est constitué d'une carte de connexion 5 et d'une carte périphérique 4.

Une carte de connexion 5 comporte l'interface de connexion amont et une interface intermédiaire 13 comportant une série de N bornes d'entrée-sorties aval 15. La carte de connexion 5 comporte en outre des liaisons électriques 16 connectant deux à deux les N bornes d'entrée-sorties amont 10 aux N bornes d'entrée-sorties aval 15 selon une permutation circulaire. Cette carte de connexion 5 permet de router les signaux électriques sans aucune intelligence logicielle.

Dans l'exemple de la figure 1, les bornes d'entrée-sortie avals 15 de l'interface intermédiaire 13 sont des broches électriques femelles, au nombre de 3 et disposées selon le même motif en ligne que les bornes des interfaces 10 et 12.

Une carte périphérique 4 comporte l'interface de connexion aval 12 et une interface intermédiaire 14 comportant une série de N bornes d'entrée-sorties amont 17 disposées selon le même motif que les bornes d'entrée-sortie avals 15 de l'interface intermédiaire 13.

Dans l'exemple de la figure 1, les bornes d'entrée-sortie amont 17 de l'interface intermédiaire 14 sont des broches électriques mâles, au nombre de 3 et disposées selon le même motif en ligne.

La carte périphérique 4 comporte en outre des liaisons électriques 19 connectant deux à deux les N bornes d'entrée-sorties amont 17 aux N bornes d'entrée-sorties aval 18 de même rang dans le motif.

Une des liaisons électriques 19 de la carte périphérique 4 est une liaison de commande locale comportant un module électronique de communication 20.

Le module électronique de communication 20 du i-ème élément modulaire 2 reçoit le signal qui lui est adressé par l'unité de commande 6 de l'élément maître 3 par la i-ème borne d'entrée sortie amont 9.

Les fiches mâles et les fiches femelles sont enfichables deux à deux de sorte à permettre une connexion électrique.

La connexion par enfichage d'une carte périphérique 4 sur une carte de connexion 5 fournit un élément modulaire 2. L'élément modulaire 2 est également enfichable sur un second élément modulaire 2 afin de fournir un dispositif d'interconnexion de réseau 1 modulaire.

Ainsi, le dispositif d'interconnexion de réseau 1 permet d'adresser des signaux électriques, y compris des informations de commande, à chaque module électronique de communication 20 des éléments modulaires sans besoin de mécanisme par logiciel ou hardware.

Notamment, les éléments modulaires peuvent être enfichés les uns aux autres aisément, car ils sont conçus de façon standard. Par exemple, ils peuvent être fabriqués en série.

Notamment, la permutation circulaire des liaisons électriques entre les bornes d'entrée sortie des interfaces amont et aval des éléments modulaires 2 permet que chaque borne d'entrée sortie aval de l'élément maître 3 soit connectée au module électronique de communication d'un élément modulaire 2 en particulier. Le rang de l'élément modulaire 2 détermine à quelle borne d'entrée sortie aval de l'élément maître 3 il est connecté.

Le rang de l'élément modulaire 2 s'entend de sa place dans la chaine d'élément modulaires 2 chaînés entre eux par rapport à l'élément maître 3.

Le fonctionnement d'un tel dispositif d'interconnexion de réseau 1 va à présent être décrit en référence à la Figure 2.

La figure 2 représente un dispositif d'interconnexion de réseau 1 tel celui de la figure 1, comportant deux éléments modulaires 21 et 22.

Le dispositif d'interconnexion de réseau 1 permet d'interconnecter le réseau internet 25 avec d'autres réseaux. Sur la Figure 2, les réseaux représentés sont des réseaux utilisant des technologies radio : SigFox 27 et LoRa 26.

Le dispositif d'interconnexion de réseau 1 comporte deux liaisons électriques 30 et 31, chacune connectées à l'unité de commande 6 et chacune traversant le dispositif d'interconnexion de réseau 1 à travers les deux éléments modulaires 21 et 22. L'élément modulaire 21 est de rang 1 et l'élément modulaire 22 est de rang 2.

L'élément modulaire 21 comporte un module électrique 20 (non représenté) connecté à une antenne 29. L'antenne radio 29 est compatible avec le réseau LoRa 26.

L'élément modulaire 22 comporte un module électrique 20 (non représenté) connecté à une antenne 28. L'antenne radio 28 est compatible avec le réseau SigFox 27.

La liaison électrique 30 est connectée électriquement au module électrique 20 comportant l'antenne 29, tandis que la liaison électrique 31 est connectée électriquement au module électrique 20 comportant l'antenne 28.

L'unité de commande 6 émet et reçoit des signaux électriques depuis et vers les antennes radio 28 et 29.

Les signaux électriques sont notamment des signaux de connections intercartes de type série. Par exemple, ces signaux sont de type :
- signaux de liaison série
- signaux d'interruption
- signaux d'entrée/sortie
- signaux de chip select
- signaux d'alimentation

Les signaux électriques incluent des informations de commande et de données.

Par exemple, l'unité de commande 6 génère un signal série de requête qui est acheminé par la liaison électrique 30 jusqu'à l'antenne radio 29.

Le signal de requête est transmis sous la forme d'ondes radios par l'antenne radio 29. Les ondes radio émises sont compatibles avec le réseau LoRa 26.

Le signal de requête est reçu par un compteur d'eau 32 équipé d'une antenne 33.

Le compteur d'eau 32 répond à ce signal de requête par un signal de données comportant le dernier relevé du compteur d'eau 32.

Ce signal de donnée est acheminé par la liaison électrique 30 jusqu'à l'unité de commande 6.

Par exemple, l'unité de commande 6 génère un signal série de mise à jour de l'heure qui est acheminé par la liaison électrique 31 jusqu'à l'antenne radio 28.

La montre connectée 34 reçoit le signal de mise à jour de l'heure via le réseau SigFox 27.

De même, il est possible de commander d'autres objets connectés (non représentés) tels que :
- un tracker, par exemple un collier pour chien
- un tag RFID,
- un réfrigérateur,
- une caméra de vidéosurveillance
- des lampes connectées, par exemple des lampes du mobilier urbain etc

D'autres technologies radio peuvent être envisagées, pourvu qu'un élément modulaire 2 supplémentaire soit prévu et équipé d'une antenne radio de la technologie désirée.

A présent, deux exemples de réalisation d'élément modulaire vont être décrits en référence respectivement aux figures 3 et 4 et à la figure 5.

La figure 3 représente un exemple de réalisation d'une carte périphérique 4 et d'une carte de connexion 5. Les cartes périphériques 4 représentées dans cet exemple de réalisation sont des cartes standardisées, fabriquées en série à l'identique les unes de autres. Il en est de même pour les cartes de connexion 5.

La carte périphérique 4 comporte un support 23 de la forme d'une tablette horizontale, réalisé par exemple en plastique isolant.

Un des bords latéraux 24 du support 23 est équipé d'un élément de connexion comportant l'interface de connexion aval 12 et l'interface intermédiaire 14.

L'interface de connexion intermédiaire 14 fait saillie de la surface supérieure du support 23 vers le haut et l'interface de connexion aval 12 fait saillie de la surface inférieure du support 23 vers le bas.

Les N bornes d'entrée-sorties amont 17 de l'interface intermédiaire 14 sont disposées en vis-à-vis des N bornes d'entrée-sortie avals 18 de l'interface amont 12. Chacune des N bornes d'entrée-sorties amont 17 est connectée à la borne d'entrée-sortie aval 18 qui lui fait face, par une liaison électrique 19.

Le support 23 comporte le module électronique de communication 20.

Le module électronique de communication 20 comporte un circuit imprimé 35 et des composants électriques logiques, ainsi que des moyens de connexions d'une antenne 29.

Dans l'exemple de la figure 3, l'antenne 29 est composée de deux émetteurs Tx 38 et 39 et de deux récepteurs Rx 36 et 37 afin de permettre une communication bidirectionnelle en duplex.

Les moyens de connexion sont par exemple quatre ports de câble coaxiaux afin de fixer un émetteur ou un récepteur sur chacun.

Une liaison électrique 40 connecte électriquement le circuit imprimé 35 et la liaison électrique 19 entre la borne d'entrée sortie amont 14 et la borne d'entrée sortie aval 18.

Cette liaison électrique 40 est disposée sur la liaison électrique 19 qui connecte des bornes d'entrée sortie 17 et 18 de rang 1. Pour permettre le chainage des éléments modulaires 2 entre eux et la communication de signaux électriques à chacun, toutes les cartes périphériques 4 doivent être conçues en disposant la liaison électrique 40 sur la liaison électrique 19 de bornes de même rang. En revanche, rien n'impose que le choix pour toutes les cartes périphériques 4 se porte sur le rang 1. Le choix pour toutes les cartes pourrait également se porter sur n'importe quel rang, par exemple le rang 2.

Une carte de connexion 5 est également représentée sur la figure 3. La carte de connexion est une tablette verticale, réalisée par exemple en plastique isolant.

Les N bornes d'entrée-sorties amont 10 sont disposées sur le bord supérieur de la tablette verticale. Les N bornes d'entrée-sortie aval 15 sont disposées sur le bord inférieur de la tablette verticale.

Les N bornes d'entrée-sorties amont 10 de l'interface intermédiaire 11 sont disposées en vis-à-vis des N bornes d'entrée-sortie aval 15 de l'interface aval 13. Chacune des N bornes d'entrée-sorties amont 10 est connectée à la borne d'entrée-sortie aval 15 par une liaison électrique 16, en permutation circulaire.

Comme représenté, la borne d'entrée-sortie amont 10 de rang 1 est connectée à la borne d'entrée-sortie aval 15 de rang N. La borne d'entrée-sortie amont 10 de rang i est connectée à la borne d'entrée-sortie aval 15 de rang i-1. Ce choix représenté sur la figure 3 est arbitraire et la permutation circulaire pourrait être réalisée dans l'autre sens. Par exemple, on peut choisir un autre standard de fabrication dans lequel la borne d'entrée-sortie amont 10 de rang N est connectée à la borne d'entrée-sortie aval 15 de rang 1 et la borne d'entrée-sortie amont 10 de rang i est connectée à la borne d'entrée-sortie aval 15 de rang i+1.

On peut assembler jusqu'à N cartes périphériques et N cartes de connexions ensemble afin d'obtenir le dispositif d'interconnexion de réseau 1.

Pour cela, il faut aligner les bornes d'entrée sortie aval 15 d'une carte de connexion 5 avec les bornes d'entrée sortie amont 17 d'une carte périphérique 4 et les enficher. On obtient alors un élément modulaire 2, comme représenté sur la figure 4.

Puis, il faut réitérer l'opération avec une nouvelle carte de connexion 5 et une nouvelle carte périphérique 4.

Chaque élément modulaire 2 peut être connecté à un autre élément modulaire 2 en enfichant les bornes d'entrée sortie amont 10 de l'interface de connexion amont 11 de la carte de connexion 5 d'un premier élément modulaire 2 avec les bornes d'entrée sortie aval 12 de l'interface de connexion aval 12 de la carte périphérique 4 d'un second élément modulaire 2.

L'élément maître 3 représenté sur la figure 4 comporte un support 41 de la forme d'une tablette horizontale, réalisé par exemple en plastique isolant.

Pour chaîner les éléments modulaires 2 sur l'élément maître 3, il faut enficher l'élément modulaire 2 de rang 1 sur l'élément maître 3 par l'intermédiaire des bornes d'entrée sortie aval 9 et des bornes d'entrée sortie amont 10.

Avantageusement, les dimensions des supports 23 et 41 sont sensiblement identiques. Notamment, la longueur du bord latéral 24 est identique à celle du bord latéral 25.

Avantageusement, les dimensions des cartes de connexion 5 sont sensiblement identiques aux dimensions des bords latéraux 24 et 42.

L'alignement des bornes d'entrée-sorties amont 17 et des bornes d'entrée-sorties aval 18, des bornes d'entrée-sorties amont 11 et des bornes d'entrée-sorties aval 13 permet d'améliorer notamment :
- la compacité du dispositif d'interconnexion de réseau 1,
- la facilitation de l'enfichage des cartes périphériques 4 et des cartes de connexion 5 les unes sur les autres ;
- la fabrication série des cartes périphériques standardisées.

La figure 5 représente une variante de réalisation d'éléments modulaires 2 dans lesquels il n'y a pas de carte de connexion 5. Sur la figure 5, quatre éléments modulaires 2 sont chainés entre eux.

Les éléments identiques ou similaires à ceux des figures précédentes sont référencés par les mêmes numéros.

Notamment, un élément modulaire 2 comporte un support 23 semblable à celui décrit en référence aux figures 3 et 4.

Chaque élément modulaire 2 est conçu de façon identique.

Les bornes d'entrée sortie amont 10 sont connectées directement aux bornes d'entrée sortie aval 18 par permutation circulaire.

Cette variante permet de simplifier le montage des dispositifs d'interconnexion de réseaux en réduisant le nombre d'éléments à chaîner les uns aux autres.

La figure 6 représente un mode de réalisation de l'invention dans lequel le chainage des cartes périphériques est rendu possible par la connexion de cartes de connexions 5 présentant un premier motif de disposition des bornes d'entrée sortie amont 10 à leur interface de connexion amont 11 différent d'un second motif de disposition des bornes d'entrée sortie aval 15 à leur interface intermédiaire 13.

Dans ce mode de réalisation de l'invention, les bornes d'entrée sortie amont 17 des cartes périphériques 4 sont disposées selon le second motif et les bornes d'entrée sortie aval 13 des cartes périphériques sont disposées selon le premier motif afin de rendre possible le chainage des cartes périphériques 4 par l'intermédiaire des cartes de connexions 5.

En référence à la figure 7, un schéma de chainage d'éléments modulaires 2 est représenté.

Sur ce schéma, le nombre N d'entrée-sorties de commandes électriques bidirectionnelles est égal à quatre et le nombre d'éléments modulaires 2 est égal à 5.

L'élément maître 3 comporte l'unité de unité de commande 6 (non représentée) qui est apte à générer des signaux électriques de type série pour chacune des quatre bornes 9 d'entrées-sorties de commande électriques bidirectionnelles connectées électriquement à l'unité de commande 6 de l'élément maître.

Les quatre chaines de lignes électriques portant les signaux électriques sont représentées partant des quatre bornes 9, chacune avec un format de pointillé différent, sauf la première chaine de ligne électrique partant de la première borne 9 est représentée en trait plein.

Comme représenté, chaque chaîne de ligne électrique alimente un module électronique de communication respectif 201, 202, 203 et 204 en fonction du rang de la borne 9 à laquelle la chaîne de ligne électrique est attachée.

Notamment, sur cette figure, le module électronique de communication 201 est alimenté électriquement et en signaux de commande par la ligne électrique représentée en trait plein.

Cette ligne électrique n'est pas interrompue après le module électronique de communication 201. Au contraire, cette ligne électrique continue par la connexion entre la borne amont 10 de rang 1 et la borne aval 15 de rang 2 de l'élément modulaire 2.

Ainsi, les signaux de commandes et l'alimentation électrique portée par la ligne électrique connectée à la borne 9 de rang 1 de l'élément maître 3 sont acheminés jusqu'à la borne aval 15 de l'élément modulaire 2 de rang 4.

Un cinquième élément modulaire 2 peut être connecté à l'élément modulaire 2 de rang 4 suivant le même principe que décrit précédemment.

La ligne électrique représentée en trait plein alimente donc également le module électronique de communication 205 de l'élément modulaire 2 de rang 5.

Les signaux de commande portés par la ligne électrique représentée en traits pleins alimentent donc à la fois le module électronique de communication 201 de l'élément modulaire de rang 1 et le module électronique de communication 205 de l'élément modulaire 2 de rang 5.

Avantageusement, la borne 9 de rang 1 de l'élément maître 3 est apte à délivrer un signal sur toute la longueur de la ligne électrique représentée en trait plein. Ce signal comporte le signal de commande destiné au module électronique de communication 201 et le signal de commande destiné au module électronique de communication 205, les deux signaux de commande étant multiplexés temporellement.

Bien que la figure 7 représente l'exemple d'un chainage de cinq éléments modulaires 2 à partir de quatre bornes 9 de l'élément maître 3, le même principe s'applique à n'importe quel nombre d'éléments modulaires et de bornes 9 de l'élément maître.

De même, bien que les modules électroniques de communication représentés sur la Figure 7 soient connectés à la borne amont 10 de rang 1, il est possible de concevoir des éléments modulaires dont les modules électroniques de communication sont connectés à une borne amont 10 d'un autre rang prédéfini, par exemple le dernier rang comme représenté sur la Figure 1. Le chaînage d'un nombre d'éléments modulaires 2 supérieur au nombre de bornes 9 de l'élément maître 3 serait également possible suivant le même principe que décrit précédemment.

Avantageusement, afin de permettre de connecter les éléments modulaires les uns aux autres sans se soucier de leur rang, l'élément maître 3 est apte à délivrer via chacune de ses bornes 9 un signal comportant les signaux de commandes destinés à chacun des module électroniques de communication 201, 202, 203, 204 et 205. Les signaux de commande sont alors multiplexés temporellement pour ne former qu'un seul signal distribué sur chacune des lignes électriques.

De manière générale, il est possible de permuter le rang des éléments modulaires 2 représentés sur les figures 1, 2, 4, 5, 6 et 7 dès lors que l'élément maître 3 est apte à délivrer via chacune de ses bornes 9 un signal comportant les signaux de commandes destinés à chacun des module électroniques de communication 20 porté par chacun des élément modulaires 2.

Il est également possible de permettre la permutation de rang de deux élément modulaires 2 de rangs définis en prévoyant de délivrer un signal multiplexé temporellement comportant les signaux de commandes destinés à chacun de ces élément modulaires 2 de rangs définis par les deux bornes 9 de rang correspondant.

Notamment, les motifs des bornes d'entrée sortie illustrés sur les figures e sont des exemples illustratifs. Les bornes d'entrée-sortie peuvent être disposées selon tout autre motif géométrique, par exemple en ligne dentée, ondulée, en grille, en anneaux concentriques, en motifs polygonaux tel que par exemple en quinconce etc

Notamment, une carte périphérique peut être équipée à son interface intermédiaire et à son interface aval de fiches toutes mâles, dans ce cas la carte de connexion sera équipée de fiches toutes femelles. Inversement, une carte périphérique peut être équipée à son interface intermédiaire et à son interface aval de fiches toutes femelles, dans ce cas la carte de connexion sera équipée de fiches toutes mâles.

L'usage du verbe « comporter », « comprendre » ou « inclure » et de ses formes conjuguées n'exclut pas la présence d'autres éléments ou d'autres étapes que ceux énoncés dans une revendication. L'usage de l'article indéfini « un » ou « une » pour un élément ou une étape n'exclut pas, sauf mention contraire, la présence d'une pluralité de tels éléments ou étapes.

Dans les revendications, tout signe de référence entre parenthèses ne saurait être interprété comme une limitation de la revendication.

## Revendications

1. Dispositif de communication modulaire (1) comportant
- un élément maître (3) comportant une unité de commande (6) apte à générer des signaux électriques de type série, comportant en outre N entrées-sorties de commande (9) électriques bidirectionnelles, chacune connectée électriquement à l'unité de commande (6),
- une série d'éléments modulaires (2), chaque élément modulaire (2) comportant :
o une interface de connexion amont (11, 14) comportant
une série de N bornes d'entrée-sorties amont (10, 17) disposées à des emplacements formant un motif prédéterminé,
o une interface de connexion aval (12, 13) comportant une série de N bornes d'entrée-sorties aval (18, 15) disposées à des emplacements formant le même motif prédéterminé,
o une pluralité de liaisons électriques bidirectionnelles (16, 19), chaque liaison électrique bidirectionnelle reliant une borne d'entrée-sortie amont (10) située à un emplacement de rang i au sein du motif prédéterminé de l'interface de connexion amont (11) à une borne d'entrée-sortie aval (18) située à un emplacement de rang i-1 au sein du motif prédéterminé de l'interface de connexion aval (12), de manière à réaliser une permutation circulaire entre les rangs des bornes d'entrée-sortie amont (10) et aval (18) reliées électriquement deux à deux, et dans laquelle l'une des liaisons électriques (16, 19) est une liaison de commande locale (40) desservant un module électronique de communication (20) auquel sont destinés les signaux électriques de type série, dans laquelle la borne d'entrée-sortie amont (17, 10) reliée à ladite liaison de commande locale (40) est une borne de commande locale amont disposée à un emplacement de rang prédéterminé au sein du motif de l'interface de connexion amont (11), de sorte que l'emplacement de la borne de commande locale amont au sein du motif de l'interface de connexion amont (11) soit le même emplacement pour tous les éléments modulaires (2),
dans lequel les éléments modulaires (2) sont connectés les uns aux autres via les interfaces de connexion amont (11) et aval (12), l'interface de connexion amont (11) de chaque élément modulaire (2) et l'interface de connexion aval (12) de chaque élément modulaire (2) étant complémentaires et aptes à connecter les bornes d'entrée-sortie aval (18) d'un élément modulaire (2) aux bornes d'entrée-sortie amont (10) de même rang de l'élément modulaire (2) suivant,
dans lequel les bornes d'entrée sortie amont (10) du premier élément modulaire (2) de la série sont connectées aux bornes entrées-sorties de commande (9) électriques bidirectionnelles de l'élément maître (3),
et dans lequel la série d'éléments modulaires (2) comporte un nombre d'éléments modulaires (2) supérieur à N.

2. Dispositif selon la revendication 1, dans lequel l'unité de commande est configurée pour générer un signal électrique multiplexé sur une des N entrées-sorties de commande (9) électriques bidirectionnelles, le signal électrique comportant des premiers signaux de commandes destinés à un premier module électronique de communication (20) d'un premier élément modulaire (2) de la série d'éléments modulaires et deuxièmes signaux de commandes destinés à un deuxième module électronique de communication (20) d'un deuxième élément modulaire (2) de la série d'éléments modulaires, les premiers signaux de commandes et les deuxièmes signaux de commandes étant multiplexés temporellement.

3. Dispositif selon la revendication 1 ou 2, dans lequel un rang i du premier élément modulaire (2) dans la série d'éléments modulaires (2) et un rang j du deuxième élément modulaire (2) dans la série d'éléments modulaires (2) présente une relation j=i[N], de sorte que le premier élément modulaire et le deuxième élément modulaire sont reliés en série à ladite entrée-sortie de commande (9) électriques bidirectionnelle.

4. Dispositif selon la revendication 1, dans lequel l'unité de commande est configurée pour générer un signal électrique multiplexé sur deux des N entrées-sorties de commande (9) électriques bidirectionnelles, le signal électrique comportant des premiers signaux de commandes destinés à un premier module électronique de communication (20) d'un premier élément modulaire (2) de la série d'éléments modulaires et des deuxièmes signaux de commandes destinés à un deuxième module électronique de communication (20) d'un deuxième élément modulaire (2) de la série d'éléments modulaires, les premiers signaux de commandes et les deuxièmes signaux de commandes étant multiplexés temporellement.

5. Dispositif selon la revendication 1, dans lequel l'unité de commande est configurée pour générer un signal électrique multiplexé sur l'ensemble des N entrées-sorties de commande (9) électriques bidirectionnelles, le signal électrique multiplexé comportant des signaux de commandes destinés à chacun des modules électronique de communication (20) des éléments modulaires (2) de la série d'éléments modulaires, les signaux de commandes étant multiplexés temporellement.

6. Dispositif selon l'une quelconque des revendications 1 à 5, dans lequel chaque élément modulaire (2) comporte une carte périphérique (4), et une carte de connexion (5),
- la carte périphérique (4) comportant :
∘ l'interface de connexion aval, la carte périphérique (4) comportant en outre :
une interface intermédiaire (14) comportant une série de N bornes d'entrée-sorties amonts (17) disposées à des emplacements formant un second motif prédéterminé,
∘ une pluralité de liaisons électriques bidirectionnelles (19), chaque liaison électrique bidirectionnelle reliant une borne d'entrée-sortie amont (17) située à un emplacement de rang i au sein du motif prédéterminé de l'interface intermédiaire à une borne d'entrée-sortie aval (18) située à un emplacement de rang i au sein du second motif prédéterminé de l'interface de connexion aval de la carte périphérique (4), dans laquelle l'une des liaisons électriques (19) est la liaison de commande locale (40), l'emplacement de la borne de commande locale amont au sein du motif de l'interface intermédiaire (14) étant le même emplacement pour toutes les cartes périphériques (4),
- la carte de connexion (5) comportant
∘ l'interface de connexion aval (11), la carte de connexion (5) comportant en outre :
∘ une interface intermédiaire (13) comportant une série de N bornes d'entrée-sorties aval (15) disposées à des emplacements formant le même second motif prédéterminé,
∘ une pluralité de liaisons électriques (16) bidirectionnelles, chaque liaison électrique bidirectionnelle reliant une borne d'entrée-sortie amont (10) située à un emplacement de rang i au sein du second motif prédéterminé de l'interface de connexion aval (11) de la carte de connexion (5) à
∘ une borne d'entrée-sortie aval (15) située à un emplacement de rang i-1 au sein du motif prédéterminé de l'interface intermédiaire (13), de manière à réaliser une permutation circulaire entre les rangs des bornes d'entrée-sortie amont (10) et aval (15) reliées électriquement deux à deux,
la carte périphérique (4) et la carte de connexion (5) étant connectées l'une à l'autre via les interfaces intermédiaires (13, 14), l'interface intermédiaire (13) de la carte de connexion (5) et l'interface intermédiaire (14) de la carte périphérique (4) étant complémentaires et aptes à connecter les bornes d'entrée-sorties amonts (17) de l'interface intermédiaire (14) de la carte périphérique (4) aux bornes d'entrée-sorties aval (15) de même rang de l'interface intermédiaire (13) de la carte de connexion (5).

7. Dispositif selon l'une quelconque des revendications 1 à 5, dans lequel chaque élément modulaire (2) comporte une carte périphérique (4), et une carte de connexion (5),
- la carte périphérique (4) comportant :
∘ l'interface de connexion amont (14), la carte périphérique (4) comportant en outre :
∘ une interface intermédiaire (12) comportant une série de N bornes d'entrée-sorties aval (18) disposées à des emplacements formant un second motif prédéterminé,
∘ une pluralité de liaisons électriques bidirectionnelles (19), chaque liaison électrique bidirectionnelle reliant une borne d'entrée-sortie amont (17) située à un emplacement de rang i au sein du motif prédéterminé de l'interface de connexion amont (14) à une borne d'entrée-sortie aval (18) située à un emplacement de rang i au sein du second motif prédéterminé de l'interface intermédiaire (18) de la carte périphérique (4), dans laquelle l'une des liaisons électriques (19) est la liaison de commande locale (40), l'emplacement de la borne de commande locale au sein du motif de l'interface intermédiaire (12) étant le même emplacement pour toutes les cartes périphériques,
- la carte de connexion (5) comportant :
∘ l'interface de connexion aval (13), la carte de connexion (5) comportant en outre :
∘une interface intermédiaire (11) comportant une série de N bornes d'entrée-sorties amont (10) disposées à des emplacements formant le même second motif prédéterminé,
∘ une pluralité de liaisons électriques bidirectionnelles (16), chaque liaison électrique bidirectionnelle reliant une borne d'entrée-sortie amont (10) située à un emplacement de rang i au sein du second motif prédéterminé de l'interface intermédiaire (11) de la carte de connexion (5) à une borne d'entrée-sortie aval (15) située à un emplacement de rang i-1 au sein du motif prédéterminé de l'interface de connexion aval (13), de manière à réaliser une permutation circulaire entre les rangs des bornes d'entrée-sortie aval (15) et amont (10) reliées électriquement deux à deux,
la carte périphérique (4) et la carte de connexion (5) étant connectées l'une à l'autre via les interfaces intermédiaires (11, 12), l'interface intermédiaire (11) de la carte de connexion (5) et l'interface intermédiaire (12) de la carte périphérique (4) étant complémentaires et aptes à connecter les bornes d'entrée-sorties aval (18) de l'interface intermédiaire (12) de la carte périphérique (4) aux bornes d'entrée-sorties amont (10) de même rang de l'interface intermédiaire (11) de la carte de connexion (5).

8. Dispositif selon la revendication 6 ou 7, dans lequel la carte périphérique (4) comporte le module électronique de communication (20), le module électronique de communication étant configuré pour communiquer sans fil avec des objets connectés, et dans lequel les signaux électriques émis par l'unité de commande (6) sont destinés aux objets connectés (32, 34).

9. Dispositif selon l'une quelconque des revendications 1 à 8, dans lequel le module électronique de communication (20) comporte une borne radio apte à être connectée à une antenne radio (29) pour émettre des signaux radios, le module électronique de communication (20) comportant un module de traitement en bande de base apte à démoduler les signaux électriques pour obtenir des signaux radio destinés à des objets connectés.

10. Dispositif selon la revendication 9, dans lequel la borne radio est en outre apte à être connectée à une antenne radio (29) pour recevoir des signaux radios en provenance d'objets connectés, le module de traitement en bande de base étant en outre apte à démoduler les signaux radios pour obtenir des signaux électriques destinés à l'unité de commande (6).

11. Dispositif selon la revendication 9 ou 10, dans lequel le module de traitement en bande de base est configuré pour utiliser des protocoles de communication radios à longue distance, sélectionnés dans la liste consistant en : SigFox, LoRa, WM-Bus, Z-Wave.

12. Dispositif selon l'une quelconque des revendications 1 à 11, dans lequel les bornes d'entrée-sortie des interfaces de connexion aval et amont (11 et 12) comportent respectivement des connecteurs mâles et des connecteurs femelles complémentaires les uns des autres, le connecteur mâle présentant une broche conductrice d'électricité et le connecteur femelle présentant un orifice conducteur d'électricité apte à établir une liaison électrique avec la broche conductrice.

13. Dispositif selon l'une quelconque des revendications 6 à 12, dans lequel les bornes d'entrée-sortie des deux interfaces intermédiaires (13 et 14) comportent respectivement des connecteurs mâles et des connecteurs femelles complémentaires les unes des autres, le connecteur mâle présentant une broche conductrice d'électricité correspondant à une borne d'entrée-sortie amont ou aval et le connecteur femelle présentant un orifice conducteur d'électricité apte à établir une liaison électrique avec la broche conductrice.

14. Passerelle de concentration de données comportant le dispositif de communication modulaire selon l'une quelconque des revendications 1 à 13 et une interface réseau apte à établir une connexion entre un réseau et l'unité de commande (6).

## Patentansprüche

1. Modulare Kommunikationsvorrichtung (1), umfassend
- ein Hauptelement (3), welches eine Steuereinheit (6) umfasst, welche dazu in der Lage ist, serielle elektrische Signale zu erzeugen, umfassend weiterhin N bidirektionale elektrische Steuereingangs/ausgangsanschlüsse (9), jeweils elektrisch verbunden mit der Steuereinheit (6),
- eine Serie von modularen Elementen (2), wobei jedes modulare Element (2) umfasst:
o eine vorgeschaltete Verbindungsschnittstelle (11,14), umfassend eine Serie von N vorgeschalteten Eingangs/Ausgangsanschlüssen (10, 17), welche an Stellen, die ein vorgegebenes Muster bilden, angeordnet sind,
∘ eine nachgeschaltete Verbindungsschnittstelle (12, 13) umfassend eine Serie von N nachgeschalteten Eingangs/Ausgangsanschlüssen (18, 15), welche an Stellen, die ein vorgegebenes Muster bilden, angeordnet sind,
∘ eine Vielzahl von bidirektionalen elektrischen Verbindungen (16, 19), wobei jede bidirektionale elektrische Verbindung einen vorgeschalteten Eingangs/Ausgangsanschluss (10), welcher an einer Stelle mit Rang i innerhalb des vorgegebenen Musters der nachgeschalteten Verbindungsstelle (11) angeordnet ist, mit einem nachgeschalteten Eingangs/Ausgangsanschluss (12), welcher an einer Stelle mit Rang i-1 innerhalb des vorgegebenen Musters des nachgeschalteten Eingangs/Ausgangsanschluss angeordnet ist, verbindet, so dass eine kreisförmige Permutation zwischen den Rängen der vorgeschalteten Eingangs-/Ausgangsanschlüsse (10) und der nachgeschalteten Eingangs/Ausgangsanschlüsse (18), welche paarweise elektrisch miteinander verbunden sind, erzeugbar ist, und wobei eine der elektrischen Verbindungen (16, 19) eine lokale Steuerverbindung (40) ist, welche ein elektronisches Kommunikationsmodul (20), für das die seriellen elektrischen Signale bestimmt sind, versorgt, wobei der vorgeschaltete Eingangs/Ausgangsanschluss (17,10), welcher mit der lokalen Steuerverbindung (40) verbunden ist, ein vorgeschalteter lokaler Steueranschluss ist, welcher an einer Stelle mit vorgegebenem Rang innerhalb des Musters der vorgeschalteten Verbindungsstelle (11) angeordnet ist, sodass die Anordnung des vorgeschalteten lokalen Steueranschlusses innerhalb des Musters der vorgeschalteten Verbindungsstelle (11) die gleiche Anordnung für alle modularen Elemente (2) ist,
wobei die modularen Elemente (2) miteinander mittels den vorgeschalteten (11) und nachgeschalteten (12) Verbindungschnittstellen verbunden sind, wobei die vorgeschaltete Verbindungschnittstelle (11) eines jeden modularen Elementes (2) und die nachgeschaltete Verbindungsstelle (12) eines jeden modularen Elementes (2) komplementär sind und dazu in der Lage sind, die nachgeschalteten Eingangs/Ausgangsanschlüsse (18) eines modularen Elementes (2) mit den vorgeschalteten Eingangs/Ausgangsanschlüssen (10) des gleichen Ranges des folgenden modularen Elementes (2) zu verbinden,
wobei die vorgeschalteten Eingangs/Ausgangsanschlüsse (10) des ersten modularen Elementes (2) der Serie mit den bidirektionalen elektrischen Steuereingangs/ausgangsanschlüssen (9) des Hauptelementes (3) verbunden sind,
und wobei die Serie der modularen Elemente (2) eine Anzahl von modularen Elementen (2) größer als N umfasst.

2. Vorrichtung gemäß Anspruch 1, wobei die Steuereinheit konfiguriert ist, um ein elektrisches Multiplex-Signal auf einem der N bidirektionalen elektrischen Steuereingangs/ausgangsanschlüssen (9) zu erzeugen, wobei das elektrische Signal erste Steuersignale umfasst, welche für ein erstes elektronisches Kommunikationsmodul (20) eines ersten modularen Elementes (2) der Serie der modularen Elemente bestimmt sind, und zweite Steuersignale, welche für ein zweites elektronisches Kommunikationsmodul (20) eines zweiten modularen Elementes (2) der Serie der modularen Elemente bestimmt sind, wobei die ersten Steuersignale und die zweiten Steuersignale zeitweise multiplex sind.

3. Vorrichtung gemäß Anspruch 1 oder 2, wobei ein Rang i des ersten modularen Elementes (2) in der Serie der modularen Elemente (2) und ein Rang j des zweiten modularen Elementes (2) in der Serie der modularen Elemente (2) eine Gleichung j=i[N] aufweisen, sodass das erste modulare Element und das zweite modulare Element seriell mit dem bidirektionalen elektrischen Steuereingangs/ausgangsanschluss (9) verbunden sind.

4. Vorrichtung gemäß Anspruch 1, wobei die Steuereinheit konfiguriert ist, um ein elektrisches Multiplex-Signal auf zwei der N bidirektionalen elektrischen Steuereingangs/ausgangsanschlüsse (9) zu erzeugen, wobei das elektrische Signal erste Steuersignale umfasst, welche für ein erstes elektronisches Kommunikationsmodul (20) der Serie der ersten modularen Elemente (2) bestimmt sind, und zweite Steuersignale, welche für ein zweites elektronisches Kommunikationsmodul (20) eines zweiten modularen Elementes (2) der Serie der modularen Elemente bestimmt sind, wobei die ersten Steuersignale und die zweiten Steuersignale zeitweise multiplex sind.

5. Vorrichtung gemäß Anspruch 1, wobei die Steuereinheit konfiguriert ist, um ein elektrisches Multiplex-Signal auf der Gesamtheit der N bidirektionalen elektrischen Steuereingangs/ausgangsanschlüsse (9) zu erzeugen, wobei das elektrische Multiplex-Signal Steuersignale umfasst, welche für jedes der elektronischen Kommunikationsmodule (20) der modularen Elemente (2) der Serie der modularen Elemente bestimmt sind, wobei die Steuersignale zeitweise multiplex sind.

6. Vorrichtung gemäß einem der Ansprüche 1 bis 5, wobei jedes modulare Element (2) eine Peripheriekarte (4) und eine Verbindungskarte (5) umfasst,
- wobei die Peripheriekarte (4) umfasst:
∘ die nachgeschaltete Verbindungsstelle, wobei die Peripheriekarte (4) weiterhin umfasst:
eine Zwischenschnittstelle (14) umfassend eine Serie von N nachgeschalteten Eingangs/Ausgangsanschlüssen (17), welche an Stellen angeordnet sind, die ein zweites vorgegebenes Muster bilden,
∘ eine Vielzahl von bidirektionalen elektrischen Verbindungen (19), wobei jede bidirektionale elektrische Verbindung einen vorgeschalteten Eingangs/Ausgangsanschluss (17), welcher an einer Stelle mit Rang i innerhalb des vorgegebenen Musters der Zwischenschnittstelle angeordnet ist, mit einem nachgeschalteten Eingangs/Ausgangsanschluss (18), welcher an einer Stelle mit Rang i innerhalb des vorgegebenen Musters der nachgeschalteten Verbindungschnittstelle der Peripheriekarte (4) angeordnet ist, verbindet, wobei eine der elektrischen Verbindungen (19) die lokale Steuerverbindung (40) ist, wobei die Anordnung des vorgeschalteten Steueranschlusses innerhalb des Musters der Zwischenschnittstelle (14) die gleiche Anordnung für alle Peripheriekarten (4) ist,
- wobei die Verbindungskarte (5) umfasst
∘ die nachgeschaltete Verbindungschnittstelle (11), wobei die Verbindungskarte (5) weiterhin umfasst:
∘ eine Zwischenschnittstelle (13), umfassend eine Serie von N nachgeschalteten Eingangs/Ausgangsanschlüssen (15), welche an Stellen angeordnet sind, die dasselbe zweite vorgegebenen Muster bilden,
∘ eine Vielzahl von bidirektionalen elektrischen Verbindungen (16), wobei jede bidirektionale elektrische Verbindung einen vorgeschalteten Eingangs/Ausgangsanschluss (10), welcher an einer Stelle mit Rang i innerhalb des vorgegebenen zweiten Musters der nachgeschalteten Verbindungsstelle (11) der Verbindungskarte (5) angeordnet ist, mit einem nachgeschalteten
∘ Eingangs/Ausgangsanschluss (15), welcher an einer Stelle mit Rang i-1 innerhalb des vorgegebenen Musters der Zwischenschnittstelle (13) angeordnet ist, verbindet, so dass eine kreisförmige Permutation zwischen den Rängen der vorgeschalteten Eingangs/Ausgangsanschlüsse (10) und der nachgeschalteten Eingangs/Ausgangsanschlüsse (15), welche paarweise elektrisch miteinander verbunden sind, erzeugbar ist,
wobei die Peripheriekarte (4) und die Verbindungskarte (5) miteinander mittels der Zwischenschnittstelle (13, 14) verbunden sind, wobei die Zwischenschnittstelle (13) der Verbindungskarte (5) und die Zwischenschnittstelle (14) der Peripheriekarte (4) komplementär sind und dazu in der Lage sind, die vorgeschalteten Eingangs/Ausgangsanschlüsse (17) der Zwischenschnittstelle (14) der Peripheriekarte (4) mit den nachgeschalteten Eingangs/Ausgangsanschlüssen (15) mit gleichem Rang der Zwischenschnittstelle (13) der Verbindungskarte (5) zu verbinden.

7. Vorrichtung gemäß einem der Ansprüche 1 bis 5, wobei jedes modulare Element (2) eine Peripheriekarte (4) und eine Verbindungskarte (5) umfasst,
- wobei die Peripheriekarte (4) umfasst:
∘ die vorgeschaltete Verbindungschnittstelle (14), wobei die Peripheriekarte (4) weiterhin umfasst:
∘ eine Zwischenschnittstelle (12), umfassend eine Serie von N nachgeschalteten Eingangs /Ausgangsanschlüssen (18), welche an Stellen, die ein zweites vorgegebenes Muster bilden, angeordnet sind,
∘ eine Vielzahl von bidirektionalen elektrischen Verbindungen (19), wobei jede bidirektionale elektrische Verbindung einen vorgeschalteten Eingangs/Ausgangsanschluss (17), welcher an einer Stelle mit Rang i innerhalb des vorgegebenen Musters der vorgeschalteten Verbindungschnittstelle (14) angeordnet ist, mit einem nachgeschalteten Eingangs/Ausgangsanschluss (18), welcher an einer Stelle mit Rang i innerhalb des zweiten vorgegebenen Muster der Zwischenschnittstelle (12) der Peripheriekarte (4) angeordnet ist, verbindet, wobei eine der elektrischen Verbindungen (19) die lokale Steuerverbindung (40) ist, wobei die Anordnung des lokalen Steueranschlusses innerhalb des Musters der Zwischenschnittstelle (12) die gleiche Anordnung für alle Peripheriekarten ist,
- wobei die Verbindungskarte (5) umfasst:
∘ Die nachgeschaltete Verbindungschnittstelle (13), wobei die Verbindungskarte (5) weiterhin umfasst:
∘ Eine Zwischenschnittstelle (11), umfassend eine Serie von N vorgeschalteten Eingangs -/Ausgangsanschlüssen (10), welche an Stellen, die dasselbe zweite vorgegebenen Muster bilden, angeordnet sind,
∘ eine Vielzahl von bidirektionalen elektrischen Verbindungen (16), wobei jede bidirektionale elektrische Verbindung einen vorgeschalteten Eingangs/Ausgangsanschluss (10), welcher an einer Stelle mit Rang i innerhalb des zweiten vorgegebenen Musters der Zwischenschnittstelle (11) der Verbindungskarte (5) angeordnet ist, mit einem nachgeschalteten Eingangs/Ausgangsanschluss (15), welcher an einer Stelle mit Rang i-1 innerhalb des vorgegebenen Musters der nachgeschalteten Verbindungsstelle (13) angeordnet ist, verbindet, so dass eine kreisförmige Permutation zwischen den Rängen der nachgeschalteten Eingangs/Ausgangsanschlüsse (15) und der vorgeschalteten Eingangs/Ausgangsanschlüsse (10), welche paarweise elektrisch miteinander verbunden sind, erzeugbar ist,
wobei die Peripheriekarte (4) und die Verbindungskarte (5) miteinander mittels den Zwischenschnittstellen (11,12) verbunden sind, wobei die Zwischenschnittstelle (11) der Verbindungskarte (5) und die Zwischenschnittstelle (12) der Peripheriekarte (4) komplementär sind und dazu in der Lage sind, die nachgeschalteten Eingangs/Ausgangsanschlüsse (18) der Zwischenschnittstelle (12) der Peripheriekarte (4) mit den vorgeschalteten Eingangs/Ausgangsanschlüssen (10) des gleichen Ranges der Zwischenschnittstelle (11) der Verbindungskarte (5) zu verbinden.

8. Vorrichtung gemäß Anspruch 6 oder 7, wobei die Peripheriekarte (4) das elektronische Kommunikationsmodul (20) umfasst, wobei das elektronische Kommunikationsmodul für die drahtlose Kommunikation mit verbundenen Objekten konfiguriert ist, wobei die von der Steuereinheit (6) gesendeten elektrischen Signale für die verbundenen Objekte (32, 34) bestimmt sind.

9. Vorrichtung gemäß einem der Ansprüche 1 bis 8, wobei das elektronische Kommunikationsmodul (20) einen Funkanschluss umfasst, welcher mit einer Funkantenne (29) verbindbar ist, um Funksignale zu senden, wobei das elektronische Kommunikationsmodul (20) ein Basisbandverarbeitungsmodul umfasst, welches dazu geeignet ist, elektrische Signale zu demodulieren, um Funksignale, welche für verbundene Objekte bestimmt sind, zu erzeugen.

10. Vorrichtung gemäß Anspruch 9, wobei der Funkanschluss weiterhin mit einer Funkantenne (29) verbindbar ist, um Funksignale, welche von den verbundenen Objekten ausgehen, zu empfangen, wobei das Basisbandverarbeitungsmodul weiterhin dazu in der Lage ist Funksignale zu demodulieren, um elektrische Signale, welche für die Steuereinheit (6) bestimmt sind, zu erzeugen.

11. Vorrichtung gemäß Anspruch 9 oder 10, wobei das Basisbandverarbeitungsmodul konfiguriert ist, um Fernfunk-Kommunikationsprotokolle zu nutzen, welche aus der nachfolgenden Liste ausgesucht werden: SigFox, LoRa, WM-Bus, Z-Wave.

12. Vorrichtung gemäß einem der Ansprüche 1 bis 11, wobei die Eingangs/Ausgangsanschlüsse der nachgeschalteten und vorgeschalteten Verbindungsanschlüssen (11 und 12) jeweils komplementäre Stecker und Buchsen umfassen, wobei der Stecker elektrisch leitende Bolzen aufweist und die Buchse eine elektrisch leitende Öffnung zur Erzeugung einer elektrischen Verbindung mit dem leitenden Bolzen aufweist.

13. Vorrichtung gemäß einem der Ansprüche 6 bis 12, wobei die Eingangs/Ausgangsanschlüsse der zwei Zwischenschnittstellen (13 und 14) jeweils komplementäre Stecker und Buchsen umfassen, wobei der Stecker elektrisch leitende Bolzen aufweist, welche einem vorgeschalteten oder nachgeschalteten Eingangs/Ausgangsanschluss entsprechen, und wobei die Buchse eine elektrisch leitende Öffnung zur Erzeugung einer elektrischen Verbindung mit dem leitenden Bolzen aufweist.

14. Gateway zur Konzentrierung von Daten umfassend die modulare Kommunikationsvorrichtung gemäß einem der Ansprüche 1 bis 13 und einen Netzwerkschnittstelle, welche dazu in der Lage ist, eine Verbindung zwischen einem Netzwerk und der Steuereinheit (6) herzustellen.

## Claims

1. A modular communication device (1) comprising
- a master element (3) comprising a control unit (6) designed to generate electrical signals of the serial type, furthermore comprising N bidirectional electrical control input-outputs (9), each electrically connected to the control unit (6),
- a series of modular elements (2), each modular element (2) comprising:
o an upstream connection interface (11, 14) comprising
a series of N upstream input-output terminals (10, 17) disposed in locations forming a predetermined pattern,
∘ a downstream connection interface (12, 13) comprising a series of N downstream input-output terminals (18, 15) disposed in locations forming the same predetermined pattern,
∘ a plurality of bidirectional electrical links (16, 19), each bidirectional electrical link connecting an upstream input-output terminal (10) situated in a location of rank i within the predetermined pattern of the upstream connection interface (11) to a downstream input-output terminal (18) situated in a location of rank i-1 within the predetermined pattern of the downstream connection interface (12), in such a manner as to form a circular permutation between the ranks of the upstream (10) and downstream (18) input-output terminals electrically connected in pairs, and in which one of the electrical links (16, 19) is a local control link (40) connected to an electronic communications module (20) for which the electrical signals of the serial type are intended, in which the upstream input-output terminal (17, 10) connected to said local control link (40) is an upstream local control terminal disposed in a location of predetermined rank within the pattern of the upstream connection interface (11), in such a manner that the location of the upstream local control terminal within the pattern of the upstream connection interface (11) is the same location for all the modular elements (2),
in which the modular elements (2) are connected to one another via the upstream (11) and downstream (12) connection interfaces, the upstream connection interface (11) of each modular element (2) and the downstream connection interface (12) of each modular element (2) being complementary and designed to connect the downstream input-output terminals (18) of a modular element (2) to the upstream input-output terminals (10) of same rank of the next modular element (2),
in which the upstream input-output terminals (10) of the first modular element (2) of the series are connected to the bidirectional electric input-output control terminals (9) of the master element (3),
and in which the series of modular elements (2) comprises a number of modular elements (2) greater than N.

2. The device as claimed in claim 1, in which the control unit is configured to generate an electrical signal multiplexed onto one of the N bidirectional electrical control input-outputs (9), the electrical signal comprising first control signals intended for a first electronic communications module (20) of a first modular element (2) of the series of modular elements and second control signals intended for a second electronic communications module (20) of a second modular element (2) of the series of modular elements, the first control signals and the second control signals being multiplexed over time.

3. The device as claimed in either of claims 1 and 2, in which a rank i of the first modular element (2) in the series of modular elements (2) and a rank j of the second modular element (2) in the series of modular elements (2) has a relationship j=i[N], in such a manner that the first modular element and the second modular element are connected in series to said bidirectional electrical control input-output (9).

4. The device as claimed in claim 1, in which the control unit is configured to generate an electrical signal multiplexed onto two of the N bidirectional electrical control input-outputs (9), the electrical signal comprising first control signals intended for a first electronic communications module (20) of a first modular element (2) of the series of modular elements and second control signals intended for a second electronic communications module (20) of a second modular element (2) of the series of modular elements, the first control signals and the second control signals being multiplexed over time.

5. The device as claimed in claim 1, in which the control unit is configured to generate an electrical signal multiplexed over all of the N bidirectional electrical control input-outputs (9), the multiplexed electrical signal comprising control signals intended for each of the electronic communications modules (20) of the modular elements (2) of the series of modular elements, the control signals being multiplexed over time.

6. The device as claimed in any one of claims 1 to 5, in which each modular element (2) comprises a peripheral board (4) and a connection board (5),
- the peripheral board (4) comprising:
o the downstream connection interface, the peripheral board (4) furthermore comprising:
an intermediate interface (14) comprising a series of N upstream input-output terminals (17) disposed in locations forming a second predetermined pattern,
∘ a plurality of bidirectional electrical links (19), each bidirectional electrical link connecting an upstream input-output terminal (17) situated in a location of rank i within the predetermined pattern of the intermediate interface to a downstream input-output terminal (18) situated in a location of rank i within the second predetermined pattern of the downstream connection interface of the peripheral board (4), in which one of the electrical links (19) is the local control link (40), the location of the upstream local control terminal within the pattern of the intermediate interface (14) being the same location for all the peripheral boards (4),
- the connection board (5) comprising
∘ the downstream connection interface (11), the connection board (5) furthermore comprising:
∘ an intermediate interface (13) comprising a series of N downstream input-output terminals (15) disposed in locations forming the same second predetermined pattern,
∘ a plurality of bidirectional electrical links (16), each bidirectional electrical link connecting an upstream input-output terminal (10) situated in a location of rank i within the second predetermined pattern of the downstream connection interface (11) of the connection board (5) to
∘ a downstream input-output terminal (15) situated in a location of rank i-1 within the predetermined pattern of the intermediate interface (13), in such a manner as to form a circular permutation between the ranks of the upstream (10) and downstream (15) input-output terminals electrically connected in pairs,
the peripheral board (4) and the connection board (5) being connected together via the intermediate interfaces (13, 14), the intermediate interface (13) of the connection board (5) and the intermediate interface (14) of the peripheral board (4) being complementary and designed to connect the upstream input-output terminals (17) of the intermediate interface (14) of the peripheral board (4) to the downstream input-output terminals (15) of same rank of the intermediate interface (13) of the connection board (5).

7. The device as claimed in any one of claims 1 to 5, in which each modular element (2) comprises a peripheral board (4), and a connection board (5),
- the peripheral board (4) comprising:
∘ the upstream connection interface (14), the peripheral board (4) furthermore comprising:
∘ an intermediate interface (12) comprising a series of N downstream input-output terminals (18) disposed in locations forming a second predetermined pattern,
∘ a plurality of bidirectional electrical links (19), each bidirectional electrical link connecting an upstream input-output terminal (17) situated in a location of rank i within the predetermined pattern of the upstream connection interface (14) to a downstream input-output terminal (18) situated in a location of rank i within the second predetermined pattern of the intermediate interface (12) of the peripheral board (4), in which one of the electrical links (19) is the local control link (40), the location of the local control terminal within the pattern of the intermediate interface (12) being the same location for all the peripheral boards,
- the connection board (5) comprising:
∘ the downstream connection interface (13), the connection board (5) furthermore comprising:
∘ an intermediate interface (11) comprising a series of N upstream input-output terminals (10) disposed in locations forming the same second predetermined pattern,
∘ a plurality of bidirectional electrical links (16), each bidirectional electrical link connecting an upstream input-output terminal (10) situated in a location of rank i within the second predetermined pattern of the intermediate interface (11) of the connection board (5) to a downstream input-output terminal (15) situated in a location of rank i-1 within the predetermined pattern of the downstream connection interface (13), in such a manner as to form a circular permutation between the ranks of the downstream (15) and upstream (10) input-output terminals electrically connected in pairs,
the peripheral board (4) and the connection board (5) being connected together via the intermediate interfaces (11, 12), the intermediate interface (11) of the connection board (5) and the intermediate interface (12) of the peripheral board (4) being complementary and designed to connect the downstream input-output terminals (18) of the intermediate interface (12) of the peripheral board (4) to the upstream input-output terminals (10) of same rank of the intermediate interface (11) of the connection board (5).

8. The device as claimed in either of claims 6 and 7, in which the peripheral board (4) comprises the electronic communications module (20), the electronic communications module being configured for communicating wirelessly with connected objects, and in which the electrical signals emitted by the control unit (6) are intended for the connected objects (32, 34).

9. The device as claimed in any one of claims 1 to 8, in which the electronic communications module (20) comprises a radio terminal designed to be connected to a radio antenna (29) so as to emit radio signals, the electronic communications module (20) comprising a baseband processing module designed to demodulate the electrical signals in order to obtain radio signals intended for connected objects.

10. The device as claimed in claim 9, in which the terminal radio is furthermore designed to be connected to a radio antenna (29) for receiving radio signals originating from connected objects, the baseband processing module being furthermore designed to demodulate radio signals in order to obtain electrical signals intended for the control unit (6).

11. The device as claimed in either of claims 9 and 10, in which the baseband processing module is configured to use protocols for long-distance radio communications, selected from within the list consisting of: SigFox, LoRa, WM-Bus, Z-Wave.

12. The device as claimed in any one of claims 1 to 11, in which the input-output terminals of the downstream and upstream connection interfaces (11 and 12) respectively include mutually complementary male connectors and female connectors, the male connector having an electrically conducting pin and the female connector having an electrically conducting orifice designed to establish an electrical connection with the conducting pin.

13. The device as claimed in any one of claims 6 to 12, in which the input-output terminals of the two intermediate interfaces (13 and 14) respectively include mutually complementary male and female connectors, the male connector having an electrically conducting pin corresponding to an upstream or downstream input-output terminal and the female connector having an electrically conducting orifice designed to establish an electrical connection with the conducting pin.

14. A data hub gateway including the modular communication device as claimed in any one of claims 1 to 13 and a network interface designed to establish a connection between a network and the control unit (6).
